(19) Europäisches Patentamt
European Patent Office
Office européen des brevets

(11) EP 0 428 867 B1

(12) **EUROPÄISCHE PATENTSCHRIFT**

(45) Veröffentlichungstag und Bekanntmachung des Hinweises auf die Patenterteilung:
27.03.1996 Patentblatt 1996/13

(51) Int Cl.6: **H01J 37/09**, H01J 37/30, G02B 5/00

(21) Anmeldenummer: **90119717.8**

(22) Anmeldetag: **15.10.1990**

(54) **Verfahren zum Schutz einer Blende beim Erzeugen von Elektronenstrahlimpulsen**

Procedure for protecting an aperture during the production of electron beam pulses

Procédé de protection d'un diaphragme lors de la production de faisceaux d'électrons pulsés

(84) Benannte Vertragsstaaten:
**BE CH DE DK FR GB IT LI NL SE**

(30) Priorität: **17.11.1989 DE 3938221**

(43) Veröffentlichungstag der Anmeldung:
**29.05.1991 Patentblatt 1991/22**

(73) Patentinhaber: **MESSER GRIESHEIM GMBH D-60314 Frankfurt (DE)**

(72) Erfinder:
- **Rappat, Franz Josef**
  **W-8031 Eichenau (DE)**
- **Scheffels, Wilhelm, Dr.**
  **W-8036 Hersching (DE)**
- **Schwab, Ulrich, Dr.**
  **W-8039 Puchheim (DE)**

(56) Entgegenhaltungen:
**DE-A- 2 815 478        US-A- 4 021 636**

- **SOVIET INVENTIONS ILLUSTRATED, Woche 8136, 4. Oktober 1981, DerwentPublications Ltd, London, GB; & SU-A-684 824 (BUTKOVSKII AG) 10-11-1978**

**Beschreibung**

Die Erfindung betrifft ein Verfahren zum Schutz einer Blende beim Erzeugen von Elektronenstrahlimpulsen durch wechselweises Ablenken des Elektronenstrahles auf die Blende und auf einen Bearbeitungsort, und eine Einrichtung zu dessen Durchführung.

Beim Bearbeiten mittels Elektronenstrahlen wird das Bearbeitungsergebnis wesentlich durch die absorbierte bzw. durch Wärmeleitung einem bestimmten Volumenelement zugeführte Energie bestimmt. Aufgrund der für die verschiedenen Effekte und Werkstoffe unterschiedlichen volumenspezifischen Energieaufwendungen ergibt sich an das Elektronenstrahlgerät die Forderung, nach der Bearbeitungsaufgabe angepassten Werten der Strahlparameter. Das betrifft unter anderem die zeitliche Steuerung der Strahleinwirkdauer am vorgegebenen Bearbeitungsort.

Aus der DE 24 51 366 C3 ist ein Elektronenstrahlgerät bekannt, bei dem ein Elektronenstrahl, der durch eine magnetische Linse auf das Werkstück fokussiert wird, durch ein magnetisches Ablenksystem wechselweise auf eine unabgelenkte Arbeitsposition, in der er auf das Werkstück auftrifft und eine abgelenkte Ruheposition, in der er auf eine Blende auftrifft, ablenkbar ist.

Zum Schutz vor Überhitzung einer nur die Randbereiche des Elektronenstrahles abfangenden wassergekühlten Zwischenblende ist in der DE-A-28 15 478 eine Verstellvorrichtung für die Blende oder eine Strahlablenkanordnung vorgesehen. Dabei wird der Elektronenstrahl durch fokussieren in der Blendenöffnung bzw. Verstellung der Blende von der Blendenoberfläche so viel wie möglich abgewendet.

Der vorliegenden Erfindung liegt die Aufgabe zugrunde, bei auf die Blende abgelenktem Elektronenstrahl eine Beschädigung der Blende durch die thermische Einwirkung des Elektronenstrahles zu vermeiden.

Diese Aufgabe wird durch die im kennzeichnenden Teil des Patentanspruches 1 angegebenen Merkmale gelöst.

Die Erfindung ermöglicht die Verwendung einer Blende zum Erzeugen von Elektronenstrahlimpulsen auch bei großen Leistungen ohne Beschädigung der Blende. Durch das Verfahren werden insbesondere Aufschmelzungen der Blendenoberfläche und damit deren Zerstörung vermieden. Im folgenden wird die Erfindung unter Bezugnahme auf die Zeichnungen näher erläutert.

Es zeigen

Fig. 1    eine schematische Darstellung einer Elektronenstrahlkanone nach der Erfindung.

Fig. 2    ein Ausführungsbeispiel der Erfindung, bei dem der Elektronenstrahl mit einem Blanking-Ablenksystem wechselweise auf die Blende bzw. den Bearbeitungsort gelenkt und auf der Blende gewedelt wird.

Fig. 2a    der entsprechende Pulsstrahlstrom bei Pulsfreigabe und Pulspause.

Fig. 3    eine vorteilhafte Ausbildung einer Blende.

Fig. 4    ein Blockschaltbild für ein Ablenksystem mit zwei Ablenkrichtungen.

Fig. 5    getrennte Ablenksysteme für das wechselweise Ablenken des Elektronenstrahles auf die Blende bzw. auf einen Bearbeitungsort.

Fig. 5a    den entsprechenden Strahlstrom für eine Kreisablenkung, mit dem in Fig. 3 dargestellten Ablenksystem.

Fig. 6    eine Steuerung für die getrennte Ansteuerung der Auslenkbewegung und der Wedelung.

Fig. 7    ein Ausführungsbeispiel der Erfindung, bei dem der Elektronenstrahl mit einem Blanking-Ablenksystem wechselweise auf die Blende bzw. den Bearbeitungsort gelenkt und auf der Blende aufgeweitet wird.

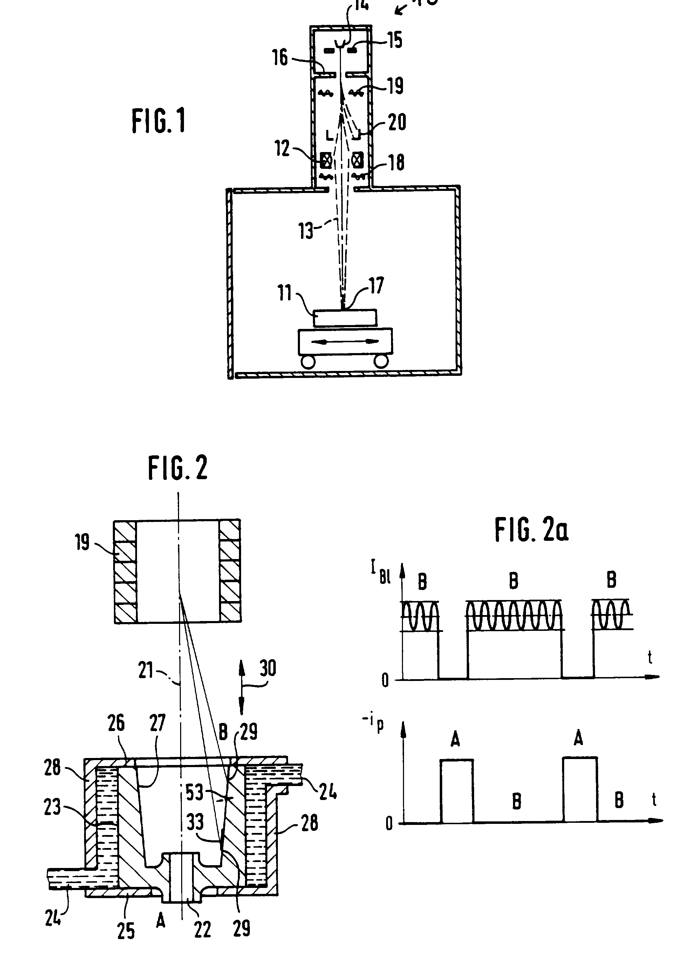

In Fig. 1 ist eine Elektronenstrahlkanone 10 zur Werkstückbearbeitung dargestellt, die in bekannter Weise ein Strahlerzeugungssystem mit einer als Elektronenstrahlquelle dienenden Kathode 14, eine Steuerelektrode 15 und eine Anode 16 enthält. Das Strahlerzeugungssystem liefert einen Elektronenstrahl 13, der durch eine magnetische Linse 12 auf das Werkstück 11 bzw. auf einen Bearbeitungsort 17 fokussiert und durch ein magnetisches Ablenksystem 18 bezüglich des Bearbeitungsortes 17 ausgerichtet wird.

Zwischen der Linse und der Anode ist bei kleineren Strahlleistungen und Pulszeiten < 10 µs mindestens ein elektrostatisches Blanking-Ablenksystem 19 oder - für höhere Strahlleistungen mindestens ein magnetisches Blanking-Ablenksystem 19 - angeordnet. Mit dem Blanking-Ablenksystem 19 können Elektronenstrahlimpulse durch das wechselweise Ablenken des Elektronenstrahles 13 auf eine vorzugsweise innerhalb des Strahlführungssystemes angeordnete Blende 20 oder den Bearbeitungsort 17 erzeugt werden.

Die Blende 20 ist bevorzugt als topfförmiges fluiddurchflossenes Gefäß (Fig. 2) mit einer koaxial zur Strahlachse 21 angeordneten Öffnung 22 ausgebildet, durch die der Elektronenstrahl 13 auf den Bearbeitungsort gelenkt werden kann. Durch eine angenähert zylindrische Innenoberfläche 27 bei axialer Position der Blendenöffnung 22 bleiben fast alle beim Auftreffen des Elektronenstrahles erzeugten rückgestreuten Elektronen innerhalb des Blendentopfes, bei gleichzeitiger Vergrößerung der Auftreff-Fläche 33 des Elektronenstrahles 13 auf der Innenoberfläche 27 der Blende 20. Die Aufweitung des Elektronenstrahles 13 wird dadurch erreicht, daß die Neigung der Innenoberfläche 27 gegenüber einer senkrecht 53 zum abgelenkten Elektronenstrahl 13 verlaufenden Innenoberfläche 27 der Blende 20 vorteilhaft verändert ist. Die Blende 20 ist an der angenähert zylindrischen Außenwand mit einem Bleimantel 28 versehen zur Abschwächung der in der Blende 20 erzeugten Röntgenstrahlung.

In der Fig. 2 ist die Blende 20 an eine Wasserkreislauf- oder -durchlaufkühlung 24 angeschlossen, die im wesentlichen den Blendenaußenmantel 23 umströmt. Selbstverständlich können auch die stirnseitige Blendenplatte 25 mit der Blendenöffnung 22 und/oder der stirnseitige Blendenrand 26 an eine Wasserkühlung angeschlossen werden.

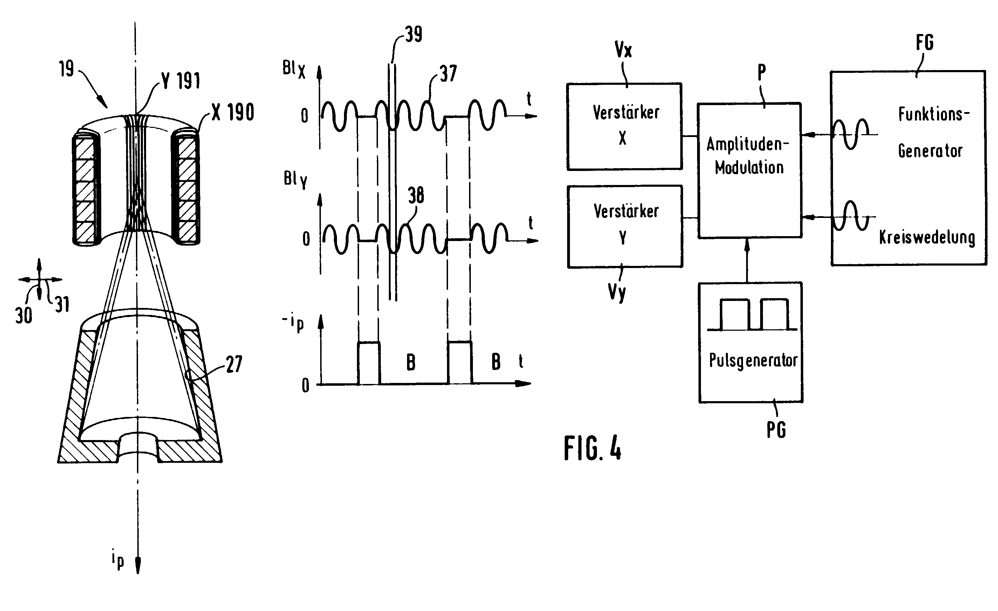

Nach einem vorteilhaften Ausführungsbeispiel kann mit dem Blanking-Ablenksystem 19 das wechselweise Hin- und Herschwenken des Elektronenstrahles 13 bezüglich der Blendenöffnung 22 und das Wedeln des Elektronenstrahles 13 auf der Innenoberfläche 27 der Blende gleichzeitig erfolgen. Dabei können je nach der Auslegung und der Ansteuerung des Blanking-Ablenksystemes 19 Wedelbahnen 29 in einer Ablenkrichtung 30 linear (Fig. 2 und Fig. 2a) oder in zwei Ablenkrichtungen 30, 31 (Fig. 4) kreisförmig erzeugt werden.

In Fig. 4 ist ein Blockschaltbild für die Ansteuerung des Blanking-Ablenksystemes 19 in zwei Ablenkrichtungen dargestellt, welches in seinem Grundaufbau auch für das lineare Wedeln geeignet ist, so daß auf eine gesonderte Beschreibung des vereinfachten Schaltungsaufbaues für das lineare Wedeln verzichtet werden kann.

In Fig. 2 ist die modulierte Ansteuerung des Blanking-Ablenksystemes 19 für das lineare Wedeln und der entsprechende Puls-Strahlstrom ip bei der Pulsfreigabe A (der Elektronenstrahl 13 trifft auf das Werkstück auf) und der Pulspause B (der Elektronenstrahl 13 trifft auf die Blende 20 auf) über der Zeit dargestellt.

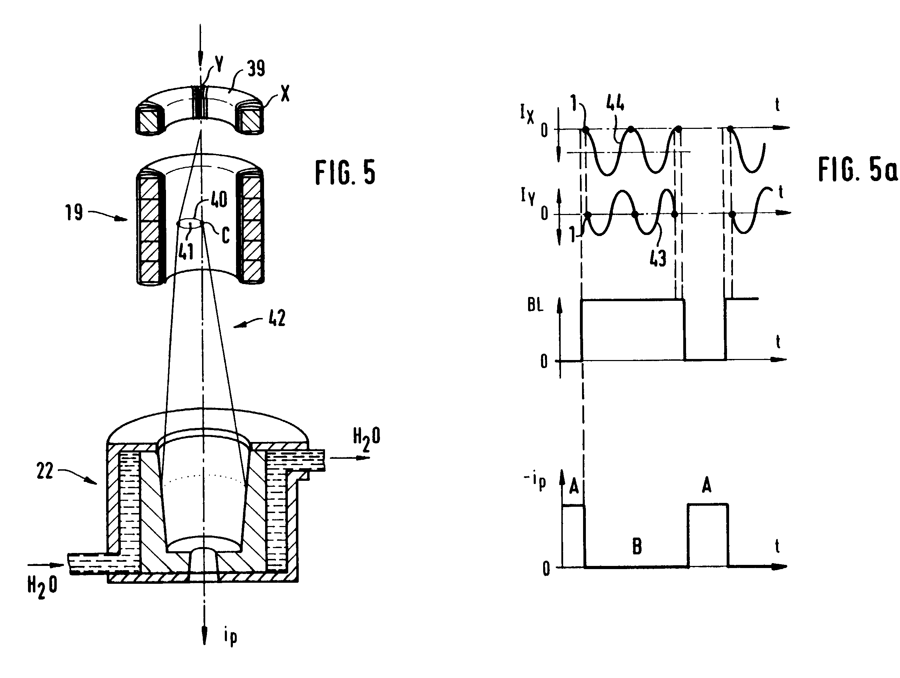

Die Pulsansteuerung eines einzigen Ablenkverstärkers Vx (Fig. 5) erfolgt dabei so, daß für das Herausschwenken des Elektronenstrahles 13 von der Blendenöffnung 22 weg nicht ein konstantes Pulsdach benutzt wird, sondern daß dem Puls eine höherfrequente Oszillation überlagert wird. Dadurch wird die Energie- bzw. Wärmeeinbringung des auf eine Auftreff-Fläche 33 der Blende 20 auftreffenden Elektronenstrahles 13 pro Zeiteinheit verringert.

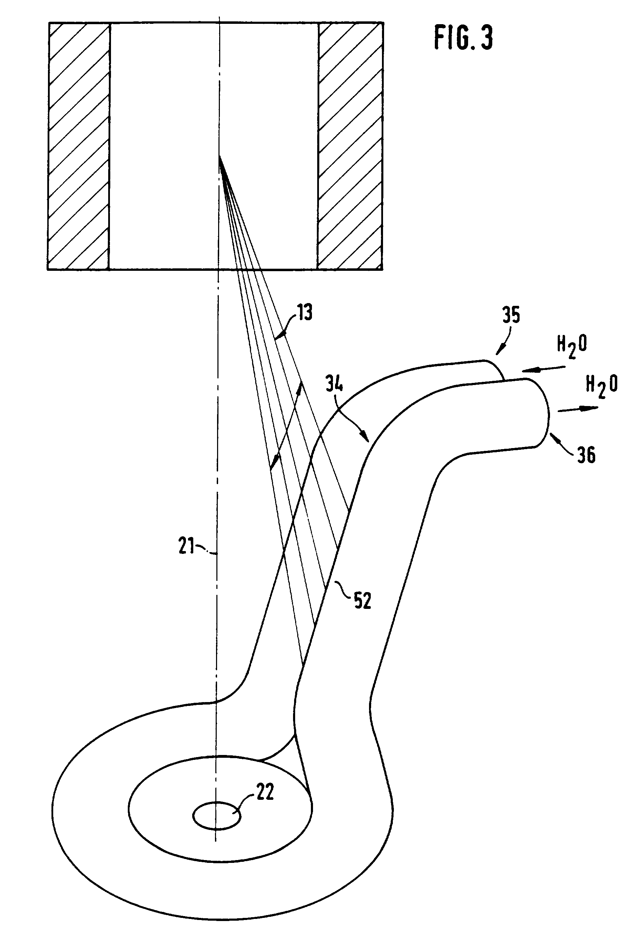

Bei höherer Strahlleistung ist es dabei günstiger, wenn der Elektronenstrahl 13 nicht auf eine ebene Fläche auftrifft, sondern in eine längliche schlitzartige aus Bauteilen 35, 36 mit gewölbten Oberflächen 52 gebildeten Vertiefung 34 mit entsprechend vergrößerter Auftreffoberfläche fällt (Fig. 3). Dabei kann diese lang gezogene Vertiefung durch zwei parallele, einander berührende wasserdurchflossene Kupferrohre 35, 36 gebildet werden. Diese sind nahezu parallel zur Strahlachse 21 des nicht abgelenkten Elektronenstrahles 13 ausgerichtet und an ihrer Berührungslinie, entlang der der gewedelte Elektronenstrahl 13 auftrifft, miteinander verlötet.

Natürlich können auch die stirnseitige Blendenplatte mit der axialen Blendenöffnung 22 sowie der Blendenaußenmantel an die Wassenkühlung angeschlossen werden.

In Fig. 4 ist ein Blanking-Ablenksystem 19 für die Ansteuerung des Blanking-Ablenksystemes in zwei Ablenkrichtungen dargestellt.

Das Blanking-Ablenksystem 19 besteht aus zwei Systemen 190, 191 für die X- und die Y-Ablenkrichtung 30, 31 und erzeugt in der Pulspause B eine schnelle Kreisablenkung, wobei der Elektronenstrahl 13 auf die Innenoberfläche 27 der Blende 20 auftrifft. Die Ausbildung der Blende 20 entspricht dabei im wesentlichen der in Fig. 2 dargestellten Ausführungsform.

Durch eine zur Blendenöffnung 22 unter einem Winkel verlaufende und die Fläche der Bodenplatte vergrößernde Neigung der Innenoberfläche 27 wird eine Aufweitung der vom Elektronenstrahl beaufschlagten Fläche erreicht; zum anderen aber kann so die Eintrittsöffnung für den (rotationssymmetrischen) Blendentopf klein gehalten werden. Dies hat den Vorteil, daß die Zahl der aus dem Topf wieder austretenden rückgesteuerten Strahlelektronen klein gehalten werden kann. Dem gleichen Zweck dient die Ausbildung der Umgebung der Blendenöffnung 22 für den Elektronenstrahl-Austritt als vorstehenden Rand.

Die Ansteuerung der Pulspause B beim Blanking-Vorgang erfolgt durch Anlegung von Sinus-Funktionen 37, 38 an die beiden Ablenkrichtungen X, Y (30, 31) des Blanking-Ablenksystemes 19; die beiden Sinus-Funktionen 37, 38 haben gleiche Maximalamplituden, sind aber zeitlich um $\frac{\pi}{2}$ (39) zueinander versetzt. Für den Beginn des Elektronenstrahlpulses (d. h.: Strahlablenkung Null) werden die Amplituden beider Sinusfunktionen gleichzeitig in kürzester Zeit auf Null reduziert, z. B. mit der in Fig. 4 dargestellten Schaltstufe P für die Amplituden-Modulation.

Die Schaltstufe P ist eingangsseitig mit einem programmierbaren Funktions-Generator FG für die Kreiswedelung und mit einem Puls-Generator PG für das Hin- und Herausschwenken des Elektronenstrahles 13 verbunden. Über ausgangsseitig mit der Schaltstufe P verbundene Ablenkverstärker Vx und Vy werden die Systeme 190 und 191 angesteuert.

Nach einem weiteren Aufführungsbeispiel (Fig. 5) wird die Kreiswedelung mit einem zusätzlichen Ablenksystem 39 ausgeführt, dessen Zeitkonstante gleich wie oder größer sein kann, als die des Ablenksystemes 19 für das Herausschwenken des Strahles. Diese Bauweise eignet sich als zusätzliche Ergänzung für hohe Strahlleistungen, wenn bis su mittleren Strahlleistungen das Blanking-System 19 mit nur einer Ablenkrichtung und ein einfacher, rotationssymmetrischer Blanking-Blendentopf 20 (wie in Fig.Fig. 2, 4 und 5) als Standard-Ausführung benutzt wird. Dabei ist zu beachten, daß die Elektronenstrahl-Kreisablenkung nur in der Pulspause B, also bei ausgelenktem Elektronenstrahl erfolgen darf, wobei entsprechend der Zeitkonstanten der Ablenksysteme 39, 19 der Einsatz der Kreisablenkung erst nach vollständigem Herausschwenken des Elektronenstrahles aus der Blendenöffnung 22 beginnt. Entsprechend kann das Einschwenken des Strahles in die Blendenöffnung 22 (das Beenden der Pulspause B) erst gestartet werden, wenn die Wedelablenk-Amplitude zu Null abgeklungen ist.

Fig. 5 zeigt die Ansteuerung der beiden Ablenkrichtungen X, Y (30, 31) für den Fall, daß das zusätzliche Ablenksystem (in Strahlrichtung) vor dem Blanking-Ablenksystem 19 angeordnet wird. Das erste Ablenksystem 39 beschreibt einen Kreis 40, der die Strahlachse 21 tangiert, wenn alle Ablenkungen Null sind und dessen Mittelpunkt 41 aber entgegen der Richtung ausgelenkt ist, in der das Blanking-Ablenksystem 19 den Elektronenstrahl 13 auf die Seite 42 schwenkt. Der Radius des Kreises 40 weist dabei die gleiche Länge auf, wie die Strecke, um die der Elektronenstrahl auf Höhe der Blanking-Blende 19 ausgelenkt wird. Bei Benutzung eines Rechners kann man den vom ersten Ablenksystem 39 beschriebenen Kreis 40 folgendermaßen ansteuern:

Sobald die Blanking-Ablenkung den Strahl aus der Blendenöffnung 22 herausgeschwenkt hat, beginnt das Ablenksystem 39 den Kreis-Umlauf grundsätzlich bei Punkt C und beendet den letzten, vor Abschluß der Pulspause B noch vollständig möglichen Umlauf wieder bei Punkt C, also an der Stelle des Kreises, an der die Spulenströme der beiden Spulenpaare X, Y gleich Null sind. Dort bleibt der Elektronenstrahl stehen, bis er mittels des Blanking-Ablenksystemes 19 wieder in die Blendenöffnung 22 hineingeschwenkt wird. In Abhängigkeit von der vorgegebenen Dauer der Pulspause B ermittelt der Rechner die mögliche Zahl der Umläufe.

In Fig. 5a ist die modulierte Ansteuerung der Blanking-Ablenksysteme 19, 39 und der entsprechende Puls-Strahlstrom ip bei der Pulsfreigabe A und der Pulspause B über der Zeit dargestellt. Die Ansteuerung der Pulspause B erfogt durch Anlegung von Sinus-Funktionen 43, 44 an die beiden Ablenkrichtungen X, Y (30, 31) des Blanking-Ablenksystemes 39. Die beiden Sinus-Funktionen 43, 44 haben gleiche Maximalamplituden, sind aber zeitlich um $\frac{\pi}{2}$ (39) zueinander versetzt. Die Sinus-Funktion 43 erreicht bei halber und die Sinus-Funktion 44 bei maximaler Amplitude den Wert Null.

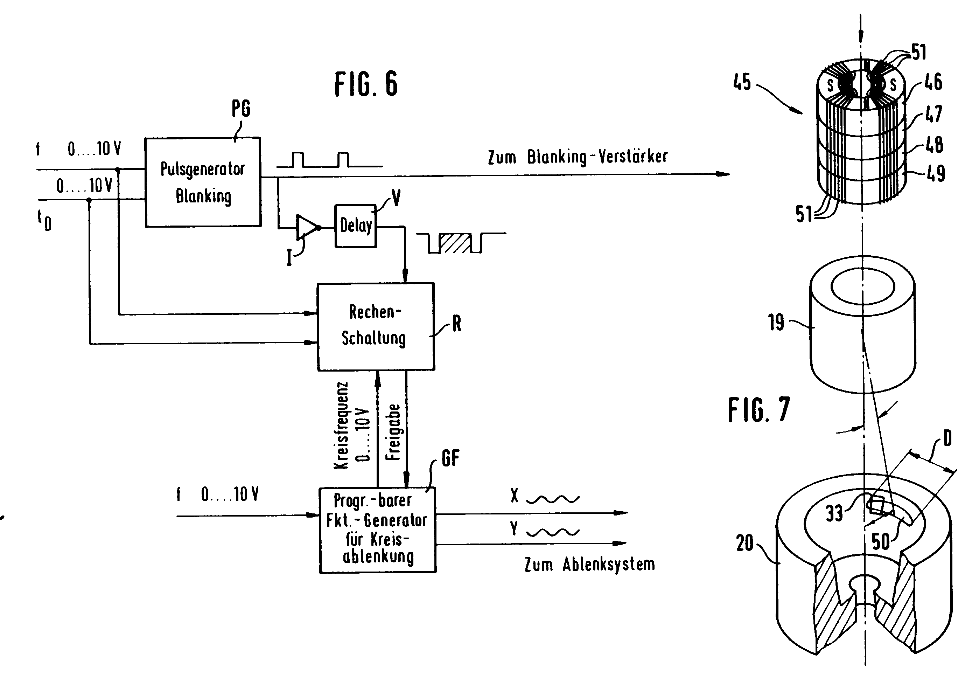

In Fig. 6 ist eine Schaltung für die Steuerung der Kreisablenkung des Ablenksystemes 39 in den Pulspausen B dargestellt. Die Schaltung besteht aus einem spannungsgesteuerten Pulsgenerator PG der (Frequenz und Tastverhältnis werden über Analogsignale 0 - 10 V vorgesehen) über einen Inverter I mit nachgeschalteter Verzögerungsschaltung V (im μs-Bereich) mit einer Rechenschaltung R verbunden ist. In der Rechenschaltung R wird aus den eingestellten Analogwerten für die Frequenz und das Tastverhältnis des Pulsgenerators und die Frequenz des programmierbaren Funktions-Generators die Zeit für die Kreiswedelung errechnet. Die Rechenschaltung R ist mit einem programmierbaren Funktionsgenerator GF verbunden, bei dem die Frequenz über eine Analogspannung 0 - 10 V einstellbar ist. Die ausgegebene Funktion kann über ein Tastenfeld einprogrammiert werden.

Das Ausgangssignal des Pulsgenerators PG wird invertiert I und über eine Verzögerungslogik V geschickt. In der Rechenschaltung R wird aus den Ansteuersignalen für den Pulsgenerator GP und den programmierbaren Funktions-Generator GF die Steuerspannung für ein Zeitglied gebildet. Das aus dem Inverter I und der Verzögerungslogik V gebildete Digitalsignal steuert in der Pulspause B über die Rechenschaltung R die Freigabe des Funktions-Generators GF, wobei dieser so programmiert ist, daß nach Wegnahme der Freigabe die programmierte Funktion noch vollständig ausgeführt wird.

In Fig. 7 ist ein Blanking-Ablenksystem 19 mit einer topfförmigen, außen verbleiten und fluidgekühlten Blende 20 entsprechend Fig. 2 bzw. Fig. 5 schematisch dargestellt. In Strahlrichtung vor dem Blanking-Ablenksystem 19 ist koaxial zur Strahlachse 21 ein elektronenoptisches Strahlaufweitungssystem 45, vorzugsweise mit Stigmatorspulen angeordnet, mittels denen der Elektronenstrahl 13 aufgeweitet werden kann. Durch diese Maßnahme wird vorteilhaft die Energie- bzw. Wärmeeinbringung des auf die Auftreff-Fläche 33 auftreffenden Elektronenstrahles 13 verringert. Während der Pulspause, also wenn der Elektronenstrahl 13 mittels des Blanking-Ablenksystemes 19 auf die gekühlte Innenoberfläche 27 des Blendentopfes 20 gerichtet wird, fließt auch Spulenstrom durch die vier Spulen 46 bis 49 des "Astigmatismus-Systemes", das so aufgebaut ist, daß dem Elektronenstrahl ein starker Astigmatismus aufgeprägt werden kann. Die Durchflutung und die azimutale Lage (in Bezug auf die des Blanking-Systemes 19) sind so gewählt, daß der sonst kreisrunde Strahlquerschnitt auf Höhe des Blendentopfes 20 zu einer langen und schlanken Ellipse 50 auseinandergezogen wird, deren große Achse D nahezu parallel zum Rand des Blendentopfes 20 ausgerichtet ist. Die große Achse D der Ellipse 50 weist vorzugsweise eine Länge von mehr als 10 mm auf, die mittels einer vorgegebenen Anzahl von Ampere-Windungen 51 in den Spulen des Astigmatismus-Systemes und durch die Länge dieses Systemes (in Strahlrichtung), d. h. die Länge des aus mehreren Ferritringen aufgebauten "Eisenkerns", um den die Spulen gewickelt werden, erreicht wird. Vorteilhaft kann für eine festgelegte elektronenoptische "Wirkung" des Systemes bei konstant vorgegebenem Spulenstrom bei einer Verlängerung des Kerns die Windungszahl der Spulen verringert und so die Drenzfrequenz des Systemes erhöht werden. Diese muß hoch sein (z. B. 10 kHz oder größer), damit die Stromänderungs-Flanke beim Ein- bzw. Ausschalten des Spulenstroms kurz genug ist.

Entsprechend der Zeitkonstanten vom Blanking-Ablenksystem 19 und Strahlaufweitungs-System 45 (z. B. des Astigmatismus-Systemes) darf der Einsatz des letzteren Systemes erst erfolgen, wenn das Herausschwenken des Elektronenstrahles 13 aus der Blendenöffnung 22 des Blendentopfes 20 mit Sicherheit abgeschlossen ist. Entsprechend muß rechtzeitig vor dem Zurückschwenken des Elektronenstrahles 13 in die Blendenöffnung 22 der Abschaltvorgang des Strahlaufweitungs-Systemes 45 (also das Abschalten des Spulenstromes des Astigmatismus-Systemes) auf Null abgeklungen sein. Diese Zeitdifferenz liegt z. B. bei weniger μ 3. Demzufolge ist bei einer gewünschten kürzeren Pulspause das Einschalten des Strahlaufweitungssystemes zu vermeiden, was bei einer programmierten Pulsansteuerung berrücksichtigt werden kann.

**Patentansprüche**

1. Verfahren zum Schutz einer Blende (20) beim Erzeugen von Elektronenstrahlimpulsen durch wechselweises Ablenken des Elektronenstrahles (13) auf die Blende (20) und auf einen Bearbeitungsort (17),
dadurch gekennzeichnet,
daß zur Vermeidung der Überhitzung der Blendenoberfläche der Elektronenstrahl (13) während seiner Auftreffzeit auf der Blende (20) periodisch gewedelt und/oder aufgeweitet wird.

2. Verfahren nach Anspruch 1,
dadurch gekennzeichnet,
daß der Elektronenstrahl (13) mit einer Frequenz größer 5 kHz periodisch linear oder kreisförmig gewedelt wird.

3. Verfahren nach Anspruch 1 oder 2,
dadurch gekennzeichnet,
daß der Elektronenstrahl (13) durch das Ansteuern desselben Ablenksystemes (19) gewedelt und/oder wechselweise auf die Blende (20) bzw. den Bearbeitungsort (17) gelenkt wird

4. Verfahren nach einem der Ansprüche 1 bis 3,
dadurch gekennzeichnet,
daß der Elektronenstrahl (13) durch das Ansteuern eines ersten Ablenksystemes (19) wechselweise auf die Blende (20) bzw. den Bearbeitungsort (17) gelenkt und durch das Ansteuern eines zweiten Ablenksystemes (39) gewedelt wird (Fig. 4).

5. Verfahren nach einem der Ansprüche 1, 2 oder 4,
dadurch gekennzeichnet,
daß der Elektronenstrahl (13) nach der Beendigung des Auslenkens auf der Blende (20) gewedelt wird und nach der Beendigung des Wedelns oder Aufweitens auf den Bearbeitungsort (17) gelenkt wird.

6. Einrichtung zur Durchführung der Verfahrens nach einem der Ansprüche 1 bis 5, mit einer im Strahlführungssystem einer Elektronenstrahlkanone (10) angeordneten wassergekühlten Blende (20) und einem Elektronenstrahlerzeuger (14, 15, 16) zum Erzeugen von Elektronenstrahlimpulsen durch wechselweises Ablenken des Elektronenstrahles (13) auf die Blende (20) und auf einen Bearbeitungsort,
gekennzeichnet durch mindestens ein Ablenksystem (19, 39) oder ein Strahlaufweitungs-System (45) zum Wedeln oder Aufweiten des Elektronenstrahles (13) und einer Steuerschaltung (Fig. 4, Fig. 6) zum Steuern des Ablenk- (19, 39) oder Strahlaufweitungssystemes (45) während oder nach der Ablenkung des Elektronenstrahles (13) auf die Blende (20).

7. Einrichtung nach Anspruch 6,
dadurch gekennzeichnet,
daß die Blende (20) als topfförmiges fluiddurchflossenes Gefäß mit einer koaxial zur Strahlachse (21) angeordneten Öffnung (20) ausgebildet ist.

8. Einrichtung nach Anspruch 6 oder 7,
dadurch gekennzeichnet,
daß die von dem Elektronenstrahl (13) beaufschlagte Auftreff-Fläche (33) bezüglich einer zum abgelenkten Elektronenstrahl (13) verlaufenden Senkrechten (53) geneigt und/oder mit gewölbter Oberfläche (52) ausgebildet ist.

**Claims**

1. In a process for the protection of a diaphragm during the generation of electron-beam pulses by means of alternately deflecting the electron beam onto the diaphragm and onto a processing site, charactericed in that in order to prevent overheating of the diaphragm surface, the electron beam (13) is periodically jiggled and/or expanded during its striking time on the diaphragm (20).

2. Process according to Claim 1, characterized in that the electron beam (13) is periodically jiggled in a circle or linearly with a frequency greater than 5 kHz.

3. Process according to Claim 1 or 2, characterized in that the electron beam (13) is jiggled by the actuation of the same deflection system (19) and/or alternately deflected onto the diaphragm (20) and onto the processing site (17).

4. Process according to one of the Claims 1 to 3, characterized in that the electron beam (13) is deflected onto the diaphragm (20) alternately by the actuation of a first deflection system (19) and onto the processing site (17) and in that it is jiggled by the actuation of a second deflection (39) system.

5. Process according to one of the Claims 1 to 4, characterized in that the electron beam (13) is jiggled after the completion of the swiveling out onto the diaphragm (20) and is deflected onto the processing site (17) after the completion of the jiggling or expanding.

6. Device according to one of the Claims 1 to 5 with a water cooled diaphragm (20) located inside the beam guiding system of an electron beam generator (10) and an electron beam generation system (14, 15, 16) for the generation of electron-beam pulses by means of alternately deflecting the electron beam (13) onto the diaphragm (20) and onto the processing site the improvement consisting of at least one deflection system (19, 39) or one beam expansion system (45) by means of which said electron beam (13) can be jiggled or expanded and a control circuit (Fig. 4, Fig. 6) by means of which said deflection system (19, 39) or beam expansion system (45) can be controlled during or after the deflection of said electron beam onto the diaphragm (20) to prevent overheating of the diaphragm surface.

7. Device according to Claim 6, characterized in that said diaphragm (20) is designed as a pot-like vessel which allows fluid to pass through with an opening (20) located coaxially to the beam axis (21).

8. Device according to Claim 6 or 7, characterized in that the striking surface (33) struck by said electron beam (13) is inclined with respect to a line (53) running vertically to said deflected electron beam and/or is designed with a curved surface (52).

**Revendications**

1. Procédé de protection d'un diaphragme (20) lors de la production de faisceaux d'électrons pulsés avec déflexion alternée du faisceau (13) d'électrons sur le diaphragme (20) et sur un point d'application (17), caractérisé en ce que pour éviter la surchauffe de la surface du diaphragme, le faisceau (13) d'électrons est, pendant les temps où il frappe le diaphragme (20), périodiquement soumis à un balancement et/ou un élargissement.

2. Procédé selon la revendication 1, caractérisé en ce que le faisceau (13) d'électrons est balancé selon une droite ou un cercle, périodiquement à une fréquence supérieure à 5 kHz.

3. Procédé selon la revendication 1 ou 2, caractérisé en ce que le faisceau (13) d'électrons est mis en balancement par commande de son propre système déflecteur (19) et/ou alternativement dévié sur le diaphragme (20) et sur le point d'application (17).

4. Procédé selon une des revendications 1 à 3, caractérisé en ce que le faisceau (13) d'électrons est dévié alternativement sur le diaphragme (20) et sur le point d'application (17), par un premier système déflecteur (19), tandis qu'un second système déflecteur (39) produit son balancement (figure 4).

5. Procédé selon une des revendications 1, 2 ou 4, caractérisé en ce que le faisceau (13) d'électrons est mis en balancement après sa déviation sur le diaphragme (20) et qu'il est dévié sur le point d'application (17) après que son balancement ou son élargissement ont été achevés.

6. Dispositif pour la mise en oeuvre de procédé selon les revendications 1 à 5, comprenant un diaphragme (20), refroidi à l'eau placé dans le système de guidage des rayons d'un canon à électrons (10) et un générateur (14, 15, 16) de faisceaux d'électrons produisant des faisceaux pulsés par déviation alternée du faisceau (13) sur le diaphragme (20) et sur un point d'application, caractérisé en ce qu'il comporte au moins un système déflecteur (19, 39) ou un système d'élargissement (45) du faisceau pour produire le balancement ou l'élargissement du faisceau (13), ainsi qu'un circuit de commande pilotant le système déflecteur (19, 39) ou le système d'élargissement (45) pendant ou après la déviation du faisceau (13) sur le diaphragme (20) (figure 4 et figure 6).

7. Dispositif selon la revendication 8, caractérisé en ce que le diaphragme (20) est un récipient de forme creuse baigné par un liquide circulant et percé d'une ouverture coaxiale (20) disposée sur l'axe (21) du faisceau d'électrons.

8. Dispositif selon la revendication 6 ou 7, caractérisé en ce que la surface (33) du diaphragme que vient frapper le faisceau (13) est inclinée par rapport à un plan (53) normal au faisceau (13) dévié, et/ou présente une forme bombée (52).

FIG.1

FIG.2

FIG.2a

# FIG.3

FIG. 4

FIG. 5

FIG. 5a

EP 0 428 867 B1

## FIG. 6

f 0....10 V
0....10 V
$t_D$

Pulsgenerator Blanking — **PG**

Zum Blanking-Verstärker

Delay — **V**

I

Rechen-Schaltung — **R**

Kreisfrequenz 0...10 V

Freigabe

f 0....10 V

Progr.-barer Fkt.-Generator für Kreis-ablenkung — **GF**

X

Y

Zum Ablenksystem

## FIG. 7

45

51
46
47
48
49

51

19

D

33

50

20

EP 0 428 867 B1